# EUROPEAN PATENT SPECIFICATION

(11) **EP 2 936 538 B1**
(45) Date of publication and mention of the grant of the patent: **11.01.2017**
(21) Application number: 13826886.7
(22) Date of filing: 20.12.2013
(51) Int. Cl.: H01J 37/077, H01J 37/305, H01J 3/02

(54) **PULSED PLASMA DEPOSITION DEVICE**
VORRICHTUNG FÜR GEPULSTE PLASMABESCHICHTUNG
DISPOSITIF DE REVÊTEMENT AU PLASMA PULSÉ

(30) Priority: 20.12.2012 IT BO20120695
(43) Date of publication of application: 28.10.2015
(73) Proprietor: Organic Spintronics S.R.L., 40129 Bologna (IT)
(72) Inventor: YARMOLICH, Dmitry, 40129 Bologna (BY); TALIANI, Carlo, I-40129 Bologna (IT)
(74) Representative: Fuochi, Riccardo
(86) International application number: PCT/IB2013/061223
(87) International publication number: WO 2014/097262

(56) References cited:
- WO-A1-2011/140481
- WO-A2-2006/105955
- US-A- 3 337 676
- US-A- 5 576 593
- US-A1- 2004 075 910

## Description

### TECHNICAL FIELD OF THE INVENTION

The present invention concerns a pulsed plasma deposition device.

More specifically, the present invention concerns a pulsed plasma deposition device with a longer lifetime without maintenance, with increased efficiency of energy transfer to the electron beam with higher fluence, and as a result, a high deposition speed with improved uniformity of the deposited film.

### STATE OF THE ART

Known pulsed plasma deposition (PPD) devices of a thin film of a given material on a substrate are designed in order to provide a so-called "Channel spark discharge" (CSD) system, which generates an electron beam normally directed towards a target comprising the material that is intended to be deposited as a thin film on a suitable substrate.

These devices usually comprise a hollow cathode, an activation electrode inside the hollow cathode, a substantially dielectric tubular element that extends through a wall of the cathode, and an anode (target) arranged opposite the tubular element at a distance of 1-40 mm from the end of the tubular element.

In use, a high voltage of negative polarity applied to the cathode causes the formation of plasma inside the cathode with the help of the activation electrode. Thus the electrons, extracted from the plasma formed inside the hollow cathode, enter into the tubular element, and the potential difference established with respect to the anode allows the electrons to be accelerated along the tubular element itself towards the target formed by the aforementioned given material or comprising such a material.

Therefore, at least a part of the given material separates from the target.

The separation of the material from the target is obtained through a known plasma formation process from the target known as ablation.

The ablation process is activated by the high amount of energy rapidly transferred onto the surface of the solid target by the electron beam generated by the pulsed plasma deposition device.

The energy is transferred to the target with extremely high density: the energy transfer is compressed over time with short pulses.

The ablated material, in the plasma state, the so-called plume, propagates towards the substrate where it condenses in the form of a thin film. The formation process of a film of material on the substrate is called deposition.

A known device of this type is described, for example, in patent applications WO2012/025947A1 and WO2010109297A2, both to the same Applicant as the present application.

Such a known device suffers from various drawbacks.

Firstly, it has been observed that the electron beams are usually generated by discharges through sparking or channelled pseudo-sparking, and in order to be able to obtain the effective transportation of these beams on the target, it is necessary to almost completely spatially neutralize the charges.

The latter can be produced, for example, using the so-called background plasma.

In any case, the thermal expansion of the plasma leads to the shortening of the circuit consisting of the anode-cathode distance, and to the end of the generation of energetic electrons.

Therefore, the beam of energetic electrons can be generated only during the discharge transition stage. The electron beam current amplitude and duration during this stage determines the efficiency of the energy transfer to the target and the ablation rate and the properties of the plasma at the anode, respectively.

The measurements of the efficiency of the energy transfer to the beam of electrons generated through "Channel Spark Discharge" (CSD) under different charge conditions have shown that a rather small part of the initial energy is actually transferred to the energetic electrons during the normal channel spark discharge process.

Moreover, as shown for example in patent applications WO2012/025947A1 and WO2010109297A2, in order to direct the plasma plume towards the substrate, the device - the capillary tube of the spark discharge channel - has its longitudinal axis that is inclined by a certain angle with respect to the surface of the target, and thus with respect to the longitudinal axis of the plasma plume that reaches the substrate.

This arrangement of the pulsed plasma deposition device with respect to the target normally generates shading phenomena on the surface of the substrate, characterized by an uneven - or asymmetric - distribution of the material coming from the target, i.e. from an asymmetric shape of the plasma plume. Moreover, the material ablated from the target penetrates inside the dielectric capillary tube of the CSD system, and also covers the outside. This material deposited not only on the substrate but also on the dielectric capillary disturbs the operation of the CSD system and thus needs replacement, limiting the lifetime of the CSD system.

Patent application WO 2006/105955A2 discloses a pulsed plasma deposition device comprising an apparatus for generating a beam of electrons, a target, and a substrate; the apparatus is suitable for generating a pulsed beam of electrons directed towards the target to determine the ablation of the material of the target in the form of a plasma plume directed towards the substrate.

The device comprises a target and focusing group of the beam of electrons towards the target, arranged between the apparatus and the target.

WO 2011/140481 discloses an apparatus for applying a coating to a substrate utilizing a plasma assisted directed vapor deposition process. The apparatus comprises one electron beam and a solenoid or deflection coil that may be positioned coaxially and/or partially proximal to the evaporant source.

### PURPOSES OF THE INVENTION

The technical task of the present invention is to improve the state of the art in the field of pulsed plasma deposition devices.

In such a technical task, a purpose of the present invention is to overcome the aforementioned drawbacks, providing a pulsed plasma deposition device with increased efficiency of energy transfer to the electrons of the beam.

Another purpose of the present invention is to increase the energy density supplied to the target.

A further purpose of the present invention is to eliminate the shading phenomena of the plasma plume on the substrate.

Another purpose of the present invention is to eliminate the contamination of the capillary tube from the ablated material in order to increase the lifetime of the device and eliminate the replacement of the capillary tube.

This task and these purposes are all accomplished by the pulsed plasma deposition device according to the attached claim 1.

The plasma deposition device according to the present invention comprises a group of transportation and focusing elements. The transportation and focussing group according to the invention is suitable for transporting the beam of electrons at a distance of 5-20 cm between the exit of the capillary of the CSD system and the target. This protects the capillary of the CSD system from the contamination of the ablated material.

The transportation and focussing group according to the invention is suitable for focussing the electron beam on a very small point of the surface of the target, about 1 mm in diameter, to increase the energy density (fluence) of the electron beam on the target. This means that any material of the target, i.e. metals, oxides, semiconductors, can be ablated in a very similar way to ablation with pulsed laser.

The transportation and focussing group according to the invention is suitable for inclining the electron beam. In other words, the capillary tube of the CSD system is positioned with a certain angle with respect to the normal to the surface of the target.

The trajectories of the electrons are inclined by this angle thanks to the geometry of the transportation and focussing group.

The ablation of the target takes place more effectively if the trajectories of the electrons are normal to the surface of the target.

Moreover, the inclination of the trajectory of the electron beam allows the propagation of the plasma plume towards the substrate without shading and in a symmetrical manner with respect to the normal to the target.

Advantageously, the film deposited on the substrate thus has the same composition as the target, with high efficiency of energy transfer.

The dependent claims refer to preferred and advantageous embodiments of the invention.

### BRIEF DESCRIPTION OF THE DRAWINGS

These and other advantages will become clearer to any man skilled in the art from the following description and from the attached tables of drawings, given as a non-limiting example, in which:
figure 1 is a schematic view of the pulsed plasma deposition device according to the present invention;
figure 2 is a detail view of some parts of the device according to the present invention.

### EMBODIMENTS OF THE INVENTION

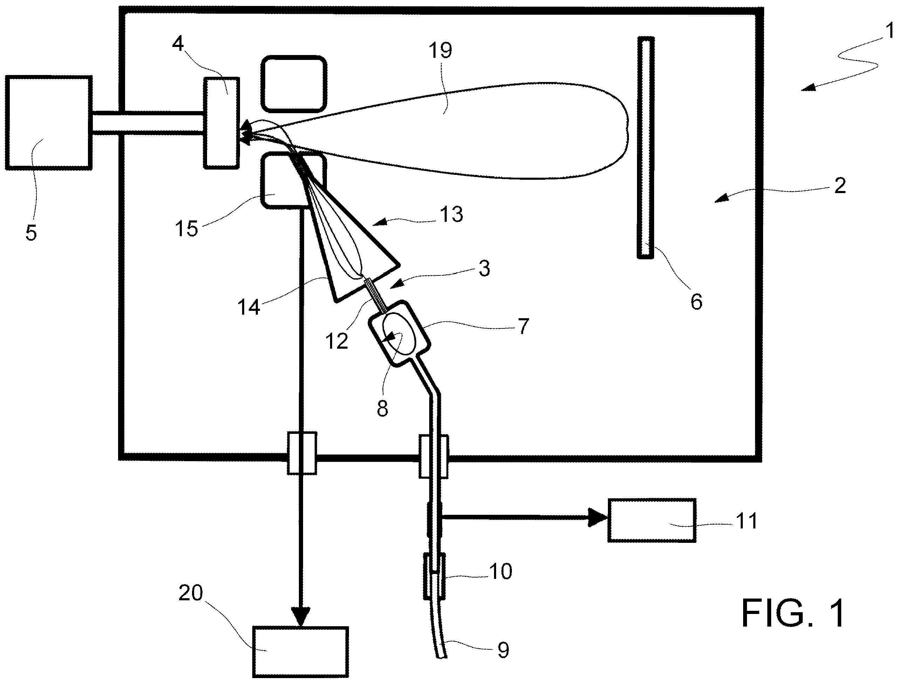

With reference to the representation of figure 1, a pulsed plasma deposition device according to the invention is wholly indicated with reference numeral 1. The device 1 according to the present invention comprises a chamber 2.

The chamber 2 is made so as to be sealed tight with respect to the external environment. The chamber 2 foresees constant pumping of the gases that provides a pressure in the range 10⁻⁵-10⁻² mBar inside the chamber. The device 1 also comprises an apparatus for generating a beam of electrons, wholly indicated with 3.

In particular, the apparatus 3 is the one described in patent application WO2012/025947A1 to the same Applicant, or one similar to it in its main characteristics.

The apparatus 3 is suitable for generating an electron beam along its longitudinal axis, as described more clearly later on.

The apparatus 3 is at least partially contained in the chamber 2.

The device also comprises a target 4, towards which the electron beam electron generated by the apparatus 3 is directed.

The target 4, which is also contained in the chamber 2, is mounted on a rotary support 5, in a *per se* known way.

The target 4 comprises a given material that must be deposited on a substrate 6.

In some embodiments of the invention, the target 4 can entirely consist of such a given material.

The target 4 is connected to the ground.

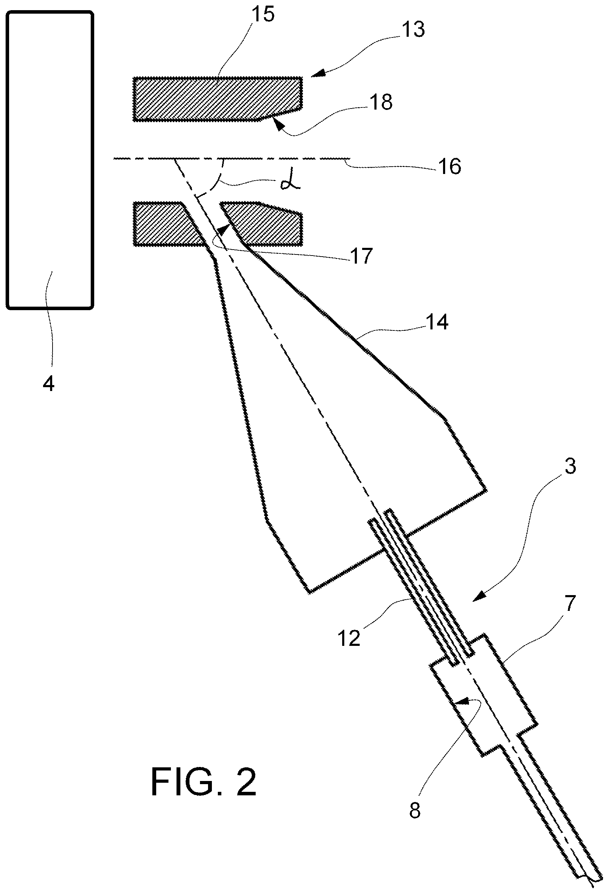

The substrate 6 is entirely contained in the chamber 2, and it is positioned opposite the target 4, and can be inclined with respect to the axis 16 of figure 2.

The substrate 6 can be of any type, without limitations for the purposes of the present invention.

For example, the substrate 6 can consist of a part or a component of electric or electronic devices such as solar cells, organic transistors, displays, light sources, and the like, or even a mechanical part or component, without limitations.

In greater detail, the apparatus 3 comprises as described more clearly in the patent application WO2012/025947A1 - a hollow element 7, which defines an inner cavity 8.

Inside the hollow element 7 the presence of an activation electrode is obligatory, but it can be of the known type.

The apparatus 3 comprises a gas supply group, of the *per se* known type and not represented, which supplies a gas into the inner cavity 8 of the hollow element 7.

The gas can, as a non-limiting example, be oxygen, argon, helium, xenon, and others.

A duct 9 for the gas connects the gas supply group - not represented - to the hollow element 7.

A gas flow limiter 10 is foreseen along the gas duct 9, and takes care of supplying the pressure difference of the gas.

The pressure of the gas in the duct 9 is higher than atmospheric pressure.

The pressure of the gas in the inner cavity 8 of the hollow element 7 is lower than atmospheric pressure (10⁻⁵ - 10⁻² mBar).

The hollow element 7 is connected to an activation group 11, which is suitable for sending the hollow element 7 an electric pulse so as to drastically reduce the potential of the hollow element 7 itself in a very short period of time, for example less than 20 ns.

The activation group 11 comprises, in particular, a pulses generator that supplies pulses at high voltage - e.g. 5-30 kV - with sudden rise time - for example 50 ns - and lower internal impedance - for example less than or equal to 15 Q - at a repetition frequency of 1-100 Hz.

The repetition frequency can theoretically reach 10 kHz.

The apparatus 3 comprises a tubular element 12, which communicates with the hollow element 7.

In greater detail, the tubular element 12 has an inner port that connects the inner cavity 8 of the hollow element 7 to the chamber 2.

In a preferred embodiment of the present invention, the tubular element 12 consists of a capillary tube, along which the electrons generated in the hollow element 7 are accelerated.

The hollow element 7 and the tubular element 12 are arranged along the longitudinal axis of the apparatus 3.

As shown clearly in figure 1 the longitudinal axis of the apparatus 3 is inclined with respect to the axis - not represented - perpendicular to the surface of the target 4.

According to an aspect of the present invention, the device 1 comprises a transportation and focussing group, wholly indicated with 13, for the beam of electrons emitted by the tubular element 12 of the apparatus 3.

The transportation and focussing group 13 is arranged between the apparatus 3 and the target 4.

In greater detail, the transportation and focussing group 13 is arranged between the tubular element 12 of the apparatus 3 and the target 4.

The transportation and focussing group 13 comprises a transportation cone 14. The transportation cone 14 is a conductive element (metal).

The transportation cone 14 is connected to the end of the tubular element 12.

In particular, the transportation cone 14 is coaxial to the tubular element 12.

The transportation cone 14 is suitable for transporting the electron beam coming out from the tubular element 12 towards the target 4, as explained more clearly hereafter.

The transportation cone 14 comprises an inner cavity.

In greater detail, as shown in figure 2, the tubular element 12 has its distal end partially inserted in the inner cavity of the transportation cone 14, so that the tubular element 12 communicates with the inner cavity of the transportation cone 14.

The transportation cone 14 can contain plasma with density less than or equal to 10¹¹ cm⁻³ to compensate for the spatial charge of the electrons.

This plasma appears in the transportation cone 14 due to the ionization of the gas with electrons scattered from the walls of the transportation cone 14.

The transportation and focussing group 13 also comprises a focussing electrode 15.

The focussing electrode 15 is directly connected to the transportation cone 14.

The focussing electrode 15 is made from conductive metal (stainless steel or other metal) electrically connected to the transportation cone 14 and to the group of elements of the self-polarization circuit 20. The focussing electrode 15 is substantially shaped like a loop, as shown in figures 1,2.

The axis of symmetry 16 of the focussing electrode 15 is perpendicular, or substantially perpendicular, to the surfaces of the target 4.

The focussing electrode 15 comprises a channel 17.

The channel 17 is foreseen through the thickness of the focussing electrode 15.

The channel 17 places the transportation cone 14 in communication with the inner volume of the focussing electrode 15.

The axis of the channel 17 is suitably inclined, with respect to the axis of symmetry 16 of the focussing electrode 15, by a certain angle α, as clearly shown in figure 2.

For example, such an angle α can be 70°45', or any other angle suitable for making an optimal emission of the electron beam from the exit of the transportation cone 14 in the focussing electrode 15.

The focussing electrode 15 also comprises an output channel 18 of the plasma plume 19.

The output channel 18 is defined by a divergent portion of the inner surface of the focussing electrode 15. According to another aspect of the present invention, the focussing electrode 15 is electrically connected to a self-polarization circuit 20.

The distance between the tubular element 12 and the target 4 is fixed in the range 5-20 cm.

In use, the electron beam is generated by the apparatus 3 in the way described, for example, in patent application WO2012/025947A1.

The activation group 11 supplies the high-voltage electrical pulses to the apparatus 3, with the parameter described earlier.

In a *per se* known way, an electron beam is thus generated, and this is extracted from the hollow element 7 through the tubular element 12.

The polarization potential of the transportation cone 14, due to a low-frequency RC filter of the self-polarization scheme foreseen in the self-polarization circuit 20, follows the potential of the cathode with a delay of about 100 ns.

The output of the transportation cone 14 emits the electron beam in the focussing electrode 15, with a trajectory that is inclined by the angle α with respect to the axis of symmetry 16 of the focussing electrode 15 itself.

The electric field existing between the target 4 - which is connected to the ground - and the focussing electrode 15 determines the curvature of the trajectory of the electron beam, as shown in figure 1.

In this way, the trajectory of the electron beam is substantially perpendicular - at least in the final portion of its journey - to the surface of the target 4.

The electron beam is also focussed - and not just curved - towards the target 4 by the electric field between the focussing electrode 15 and the target 4.

The angle α between the axis of the transportation cone 14 and the axis of symmetry of the focussing electrode 15 allows a rectilinear propagation of the plasma plume 19 without shading phenomena at the substrate 6.

In other words, the plasma plume 19 has a symmetrical shape that improves the uniformity of deposition of film on the substrate 6.

The pressure of the gas inside the transportation and focussing group 13 - transportation cone 14 and focussing electrode 15 - is optimal in the range 5.10⁻² - 5.10⁻⁵ mBar, in order to form a low-density plasma, for example plasma with a density of less than or equal to 10¹¹ cm⁻³ .

Such a low density of the plasma provides an optimal neutralization of the spatial charge of the electrons. Moreover, the low-density plasma has an impedance that is higher than the internal impedance of the generator. In this case, the electron beam has an energy distribution in which most of the electrons has the high energy gained passing through the cathode-target potential difference.

The output geometry of the focussing electrode 15 determines the focusing distance of the electron beam. It has been found experimentally that the optimal distance between the target 4 and the output of the focussing electrode 15 is in the range of 4-30 mm. Moreover, it has been found that the optimal duration of the pulse for the ablation of the target 4 is less than 20 µs.

The ablated material, while the plasma plume 19 expands from the target 4, passes through the output channel 18 of the focussing electrode 15.

During this time, the potential of the focussing electrode 15 has disappeared.

The plasma plume 19 - which has a density greater than or equal to 10¹⁴ cm⁻³ - connects the focussing electrode 15 to the target 4; due to the low resistance of this plasma - less than 10 Ω - the potential of the focussing electrode 15 decreases.

Therefore, the plasma plume 19 propagates towards the substrate 6 where it is deposited, forming a film with the same composition as the target 4, but with different stoichiometry.

The repetition of the pulses can be of a speed equal to 10 kHz, thanks to the high decay speed of the plasma of 100 µs.

This characteristic can ensure a high deposition speed of the film on the substrate 6 with a quality of the deposited film similar to that of pulsed laser ablation.

The focusing action of the focussing electrode 15 determines the generation of an electron beam with high energy density at the target 4, such an energy density being comprised in the range 10⁶ - 10⁹ W/cm². The increase in the fluence of the electron beam is due to the focussing and cannot be obtained with a standard CSD system without focusing the beam. Moreover, the electron beam with high energy is focused on the target 4 in a point of 1 mm in diameter: this allows any material of the target - for example metal, oxides, semiconductors - to be ablated in a similar way to pulsed laser ablation, with the deposited film having the same composition as the target 4.

It is thus clear that the technical task of the present invention is fully achieved.

The ablation through focused pulsed electron beam obtained with the device according to the present invention allows a more efficient energy transfer to the target 4.

The transportation of the electron beam to a distance from the channel spark discharge source that can be in the range 2-50 cm - thanks to the presence of the transportation and focussing group 13 - increases the lifetime of the tubular element 12 - i.e. the capillary tube - and the efficiency of the energy transfer to the electrons.

The uniformity of the deposited film is improved thanks to the electrostatic potential of the electrodes that attract the microparticles generated at the target 4. The normal microparticles are thus absent or at least are lesser in number in the film deposited on the substrate 6.

The device according to the present invention has low costs and high reliability.

## Claims

1. Pulsed plasma deposition device, comprising an apparatus for generating a beam of electrons (3), a target (4) and a substrate (6), said apparatus (3) being suitable for generating a pulsed beam of electrons directed towards said target (4) to determine the ablation of the material of said target (4) in the form of a plasma plume (19) directed towards said substrate (6), said device comprising a transportation and focussing group (13) of the beam of electrons towards said target (4), arranged between said apparatus (3) and said target (4) and comprising a transportation cone (14), said transportation and focussing group (15) also comprising a focussing electrode (15) directly connected to said transportation cone (14) and shaped substantially in a loop, **characterized in that** the axis of symmetry (16) of said focussing electrode (15) is perpendicular, or substantially perpendicular, to the surface of the target (4).

2. Device according to claim 1, wherein said apparatus (3) comprises a hollow element (7) having an inner cavity (8) into which a gas is fed, an activation electrode foreseen inside said hollow element (7), a tubular element (12) that communicates with said hollow element (7).

3. Device according to claim 2, wherein said transportation cone (14) is connected to the end of said tubular element (12).

4. Device according to claim 2 or 3, wherein said tubular element (12) consists of a capillary tube.

5. Device according to one of the previous claims, wherein said focussing electrode (15) comprises a channel (17), suitable for placing said transportation cone (14) in communication with the inner volume of said focussing electrode (15).

6. Device according to claim 5, wherein said channel (17) is foreseen through the thickness of said focussing electrode (15).

7. Device according to claim 6, wherein the axis of said channel (17) is inclined by an angle (α) with respect to the axis of symmetry (16) of said focussing electrode (15).

8. Device according to claim 7, wherein said angle (α) is 10-80°.

9. Device according to one of the previous claims, wherein said focussing electrode (15) is suitable for determining the curvature of the trajectory of the electron beam, thanks to the electric field existing between said target (4) and said focussing electrode (15).

10. Device according to one of the previous claims, wherein the distance between said target (4) and said focussing electrode (15) is in the range 4-30 mm.

11. Device according to one of the previous claims, wherein said focussing electrode (15) is connected to a self-polarization circuit (20).

## Patentansprüche

1. Vorrichtung für die gepulste Plasmaabscheidung, umfassend ein Gerät zur Erzeugung eines Elektronenstrahls (3), ein Target (4) und ein Substrat (6), wobei das besagte Gerät (3) für die Erzeugung eines gepulsten Elektronenstrahls geeignet ist, der zum besagten Target (4) hin gerichtet ist, um die Ablation des Materials von dem besagten Target (4) in Form einer Plasmaflamme (19), die zum Substrat (6) hin gerichtet ist, zu bedingen, die besagte Vorrichtung eine Transport- und Fokussiergruppe (13) des zum Target (4) hin gerichteten Elektronenstrahls umfasst, die zwischen dem Gerät (3) und dem besagten Target (4) angeordnet ist und einen Transportkegel (14) umfasst, die besagte Transport- und Fokussiergruppe (15) außerdem eine Fokussierelektrode (15) umfasst, die direkt mit dem besagten Transportkegel (14) verbunden und im Wesentlichen schleifenförmig geformt ist, **dadurch gekennzeichnet, dass** die Symmetrieachse (16) der besagten Fokussierelektrode (15) senkrecht oder im Wesentlichen senkrecht zu der besagten Fläche des Targets (4) ist.

2. Vorrichtung nach Anspruch 1, worin das besagte Gerät (3} ein Hohlelement (7) mit einem inneren Hohlraum (8) umfasst, in den Gas eingespeist wird, eine Aktivierungselektrode, die im Inneren des Hohlelements (7) vorgesehen ist, ein rohrförmiges Element (12), das mit dem besagten Hohlelement (7) in Verbindung steht.

3. Vorrichtung nach Anspruch 2, worin der besagte Transportkegel (14) mit dem Ende des besagten rohrförmigen Elements (12) verbunden ist.

4. Vorrichtung nach Anspruch 2 oder 3, worin das besagte rohrförmige Element (12) aus einem Kapillarrohr besteht.

5. Vorrichtung nach einem der vorangegangenen Ansprüche, worin die besagte Fokussierelektrode (15) einen Kanal (17) umfasst, der zum Verbinden des besagten Transportkegels (14) mit dem Innenvolumen der besagten Fokussierelektrode (15) geeignet ist.

6. Vorrichtung nach Anspruch 5, worin der besagte Kanal (17) durch die Dicke der besagten Fokussierelektrode (15) vorgesehen ist.

7. Vorrichtung nach Anspruch 6, worin die Achse des besagten Kanals (17) gemäß einem Winkel (α) in Bezug auf die Symmetrieachse (16) der besagten Fokussierelektrode (15) geneigt ist.

8. Vorrichtung nach Anspruch 7, worin der besagte Winkel (α) 10-80° beträgt.

9. Vorrichtung nach einem der vorangegangenen Ansprüche, worin die besagte Fokussierelektrode (15) zur Bestimmung der Krümmung der Trajektorie des Elektronenstrahls dank des bestehenden elektrischen Feldes zwischen dem besagten Target (4) und der besagten Fokussierelektrode (15) geeignet ist.

10. Vorrichtung nach einem der vorangegangenen Ansprüche, worin der Abstand zwischen dem besagten Target (4) und der besagten Fokussierelektrode (15) im Bereich von 4-30 mm liegt.

11. Vorrichtung nach einem der vorangegangenen Ansprüche, worin die besagte Fokussierelektrode (15) mit einer Schaltung für die Selbstpolarisation (20) verbunden ist.

## Revendications

1. Appareil de déposition par plasma par impulsions, comprenant un appareil pour générer un faisceau d'électrons (3), une cible (4) et un substrat (6), ledit appareil (3) étant adapté pour générer un faisceau d'électrons par impulsion dirigé vers ladite cible (4) pour déterminer l'ablation de la matière de ladite cible (4) sous la forme d'un plasma (19) dirigé vers ledit substrat (6), ledit appareil comprenant un groupe de transport et de concentration (13) du faisceau d'électrons vers ladite cible (4), disposé entre ledit appareil (3) et ladite cible (4) et comprenant un cône de transport (14), ledit groupe de transport et concentration (15) comprenant également une électrode de concentration (15) directement raccordée audit cône de transport (14) et sensiblement en forme de boucle, **caractérisé en ce que** l'axe de symétrie (16) de ladite électrode de concentration (15) est perpendiculaire, ou sensiblement perpendiculaire, par rapport à la surface de la cible (4).

2. Appareil selon la revendication 1 dans lequel ledit appareil (3} comprend un élément creux (7) comportant une cavité intérieure (8) dans laquelle un gaz est alimenté, une électrode d'activation prévue dans ledit élément creux (7), un élément tubulaire (12) en communication avec ledit élément creux (7).

3. Appareil selon la revendication 2, dans lequel ledit cône de transport (14) est raccordé à l'extrémité dudit élément tubulaire (12).

4. Appareil selon la revendication 2 ou 3, dans lequel ledit élément tubulaire (12) est composé d'un tube capillaire.

5. Appareil selon l'une quelconque des revendications qui précèdent, dans lequel ledit électrode de concentration (15) comprend un canal (17), adapté pour positionner ledit cône de transport (14) en communication avec le volume intérieur de ladite électrode de concentration (15).

6. Appareil selon la revendication 5, dans lequel ledit canal (17) est prévu à travers l'épaisseur de ladite électrode de concentration (15).

7. Appareil selon la revendication 6, dans lequel l'axe dudit canal (17) est incliné selon un angle (α) par rapport à l'axe de symétrie (16) de ladite électrode de concentration (15).

8. Appareil selon la revendication 7, dans lequel ledit angle (α) est de 10-80°.

9. Appareil selon l'une quelconque des revendications qui précèdent, dans lequel ladite électrode de concentration (15) est adaptée pour déterminer la courbe de la trajectoire du faisceau d'électrons, grâce au champ électrique existant entre ladite cible (4) et ladite électrode de concentration (15).

10. Appareil selon l'une quelconque des revendications précédentes, dans lequel la distance entre ladite cible (4) et ladite électrode de concentration (15) est dans la plage de 4-30 mm.

11. Appareil selon l'une quelconque des revendications qui précèdent, dans lequel ladite électrode de concentration (15) est raccordée à un circuit d'auto-polarisation (20).
